# EUROPEAN PATENT APPLICATION

(11) **EP 4 583 152 A2**
(43) Date of publication of application: **09.07.2025**
(21) Application number: 24211800.8
(22) Date of filing: 08.11.2024
(51) Int. Cl.: H01L 21/66

(54) **SKELETON ETCH FOR SEMICONDUCTOR CHIPS**

(30) Priority: 13.12.2023 US 202318539130
(71) Applicant: Intel Corporation, Santa Clara, CA 95054 (US)
(72) Inventor: LIVENGOOD, Richard, San Jose, 95135 (US); TAN, Shida, Saratoga, 95070 (US); PARDY, Patrick, Hillsboro, 97123 (US); RONEN, Ilan, Hadera (IL); SIDOROV, Oleg, Portland,, 97229 (US); MALIK, Tahir, Portland, 97229 (US); RAZA, Muhammad Usman, Newark, 94560 (US); SENEVIRATHNA, Bathiya, Hillsboro, 97124 (US); SENGER, Mitchell, Portland, 97209 (US)
(74) Representative: HGF

(57) **Abstract**

Methods for analyzing and altering the operation of a semiconductor device are provided. The methods include exposing an area of a semiconductor device through a selective partial etch process that creates a skeleton-like structure of metal traces. The exposed areas impose minimal invasiveness to the functionality of the device. The exposed area can facilitate probing the semiconductor device with analysis methods that provide information about the operation of the semiconductor device. Additional device functionality alteration is achieved by cutting, connecting, and re-routing interconnect layers.

## Description

### FIELD

Descriptions are generally related to semiconductor device manufacturing, and more particular descriptions are related to validation, fault isolation, failure analysis, and debugging of semiconductor devices.

### BACKGROUND

Semiconductor chips are central to intelligent devices and systems, such as personal computers, laptops, tablets, phones, servers, and other consumer and industrial products and systems. Manufacturing semiconductor chips presents a number of challenges and these challenges are amplified as devices become smaller and performance demands increase. Challenges include, for example, unwanted material interactions, precision and scaling requirements, power delivery requirements, limited failure tolerance, and material and manufacturing costs.

Design validation, failure analysis, and debugging techniques are critical parts of semiconductor product development, integrated circuit chip design, manufacturing process development, and product yield improvement. Engineering samples are generated to perform necessary validation of new products and design changes. Validation includes debugging any design, process, and/or logic issues. Additionally, circuit-level analysis is used to identify any design, timing, power, and process issues. Identifying and isolating circuits and devices that are not functioning properly is critical to failure analysis techniques. As semiconductor chips and semiconductor chip packages become more complex, it can be difficult to reach the necessary physical location in the semiconductor device in order to perform failure analysis and debugging. Being unable to physically probe areas of a chip can make it difficult or impossible to identify, validate, and implement bug fixes for silicon chips.

### BRIEF DESCRIPTION OF THE DRAWINGS

The figures are provided to aid in understanding the invention. The figures can include diagrams and illustrations of exemplary structures, assemblies, data, methods, and systems. For ease of explanation and understanding, these structures, assemblies, data, methods, and systems, the figures are not an exhaustively detailed description. Additionally, due to complexity and small scale of the structures, relative proportions of feature sizes should not be assumed to be depicted accurately. The figures therefore should not be understood to depict the entire metes and bounds of structures, assemblies, data, methods, and systems possible without departing from the scope of the invention.
**Figure 1** illustrates a cross-sectional view of an exemplary section of a semiconductor device where a partial etch process is performed.
**Figure 2** provides a cross-sectional view of an additional exemplary section of a semiconductor device where a partial etch process is performed.
**Figure 3** shows a surface view of an area of an exemplary section of a semiconductor device, such as one of Figures 2 or 3, where a partial etch process has been performed.
**Figure 4** provides a cross-sectional view of a further exemplary section of a semiconductor device where a partial etch process is performed.
**Figures 5A** - **5B** illustrate an exemplary section of a semiconductor device where a delayering and partial etch have been performed and metal traces are reconnected.
**Figures 6A** - **6B** show a portion of a semiconductor chip where dielectric removal allows access to transistors.
**Figures 7A** - **7B** illustrate example results for an electron beam probing of metal traces in a section of a semiconductor device that was subject to a partial etch.
**Figure 8** provides methods for analysis and testing of a semiconductor device.
**Figure 9** describes additional methods for analysis and testing of a semiconductor device.
**Figure 10** provides an exemplary computing system that is useful in performing processes and analyses.

Descriptions of certain details and implementations follow, including non-limiting descriptions of the figures, which depict some examples and implementations.

### DETAILED DESCRIPTION

References to one or more examples are to be understood as describing a particular feature, structure, or characteristic included in at least one implementation of the invention. The phrases "one example" or "an example" are not necessarily all referring to the same example or embodiment. Any aspect described herein can potentially be combined with any other aspect or similar aspect described herein, regardless of whether the aspects are described with respect to the same figure or element.

The words "connected" and/or "coupled" can indicate that two or more elements are in direct physical or electrical contact with each other. The term "coupled," however, can also mean that two or more elements are not in direct contact with each other and are instead separated by one or more elements but they may still co-operate or interact with each other, for example, physically, magnetically, or electrically.

The words "first," "second," and the like, do not indicate order, quantity, or importance, but rather are used to distinguish one element from another. The words "a" and "an" herein do not indicate a limitation of quantity, but rather denote the presence of at least one of the referenced items. The terms "follow" or "after" can indicate immediately following or following some other event or events. Other sequences of operations can also be performed according to alternative embodiments. Furthermore, additional operations may be added or removed depending on the application.

Disjunctive language such as the phrase "at least one of X, Y, or Z," is used in general to indicate that an element or feature, may be either X, Y, or Z, or any combination thereof (e.g., X, Y, and/or Z). Thus, this disjunctive language should be understood not to imply that certain embodiments require at least one of X, at least one of Y, or at least one of Z to each be present.

Terms such as chip, die, IC (integrated circuit) chip, IC die, microelectronic chip, microelectronic die, semiconductor device, and/or semiconductor chip are interchangeable and refer to a device comprising semiconducting materials and comprising integrated circuits.

The terms "package," "packaging," "IC package," or "chip package," "microelectronics package," or "semiconductor chip package" are interchangeable and generally refer to an enclosed carrier of one or more dies, in which the dies are attached to a package substrate and encapsulated. The package substrate provides electrical interconnects between the die(s) and other dies and/or a motherboard or other printed circuit board for I/O (input/output) communication and power delivery. A package with multiple dies can, for example, be a system in a package. A semiconductor device can be a packaged die or an unpackaged die.

A package substrate generally includes dielectric layers or structures having conductive structures on and/or embedded within the dielectric layers or structures. The conducting structures can be comprised of copper and can be in the form of trenches and vias. The dielectric layers can be, for example, build-up layers. Other structures or devices are also possible within a package substrate. Semiconductor package substrates can have cores or be coreless. Semiconductor packages having cores can have dielectric layers such as buildup layers on two sides of the core.

A "core" or "package core" generally refers to a layer usually embedded within a package substrate. The core can provide structure or stiffness to a package substrate. A core is an optional feature of a package substrate. The core can be a dielectric organic or inorganic material and may have conductive vias extending through the layer. A package core can, for example, comprise glass (such as, for example, aluminosilicate, borosilicate, alumino-borosilicate, silica, and fused silica), silicon, silicon nitride, silicon carbide, gallium nitride, or aluminum oxide. In some examples, core materials are glass-fiber reinforced organic resins such as epoxy-based resins. A further example package substrate core is FR4 (woven glass fiber reinforces epoxy).

Flow diagrams as illustrated herein provide examples of sequences of various process actions. The flow diagrams can indicate operations to be executed by a software or firmware routine, as well as physical operations. Physical operations can be performed by semiconductor processing equipment. Although shown in a particular sequence or order, unless otherwise specified, the order of the actions can be modified. Thus, the illustrated diagrams should be understood only as examples, and the process can be performed in a different order, and some actions can be performed in parallel. Additionally, one or more actions can be omitted and not all implementations will perform all actions.

Various components described can be a means for performing the operations or functions described. Each component described can include software, hardware, or a combination of these. Some components can be implemented as software modules, hardware modules, special-purpose hardware (for example, application specific hardware, application specific integrated circuits (ASICs), digital signal processors (DSPs), etc.), embedded controllers, or hardwired circuitry). Other components can be semiconductor processing and/or testing equipment that is able to perform physical operations such as, for example, lithography, probing, material deposition (for example, chemical vapor deposition, atomic layer deposition, and/or sputtering), chemical mechanical polishing, and etching.

To the extent various computer operations or functions are described herein, they can be described or defined as software code, instructions, configuration, and/or data. The software content can be provided via an article of manufacture with the content stored thereon, or via a method of operating a communication interface to send data via the communication interface. A machine-readable storage medium can cause a machine to perform the functions or operations described. A machine-readable storage medium includes any mechanism that stores information in a tangible form accessible by a machine (e.g., computing device), such as recordable/non-recordable media (e.g., read only memory (ROM), random access memory (RAM), magnetic disk storage media, optical storage media, flash memory devices). Instructions can be stored on the machine-readable storage medium in a non-transitory form. A communication interface includes any mechanism that interfaces to, for example, a hardwired, wireless, or optical medium to communicate to another device, such as, for example, a memory bus interface, a processor bus interface, an Internet connection, a disk controller.

Semiconductor chip manufacturing processes are sometimes divided into front end of the line (FEOL) processes and back end of the line (BEOL) processes. Electronic circuits and active and passive devices within the chip, such as for example, transistors, capacitors, resistors, and/or memory cells, are manufactured in what can be referred to as FEOL processes. Memory cells include, for example, electronic circuits for random access memory (RAM), such as static RAM (sRAM), dynamic RAM (DRAM), read only memory (ROM), non-volatile memory, and/or flash memory. FEOL processes can be, for example, complementary metal-oxide semiconductor (CMOS) processes. BEOL processes include metallization of the chip where interconnects are formed in dielectric layers and the feature size of the interconnect increases in layers nearer the surface of the semiconductor chip. Interconnects in, for example, semiconductor chips that are integrated into heterogeneous packages (such as, for example, packages that include memory and logic chips), can also include through silicon vias (TSVs) that transverse the semiconductor chip device region. Semiconductor devices that have TSVs can blur distinctions between BEOL and FEOL processes.

Semiconductor chip interconnects can be created by forming a trench or though-layer via by etching a trench or via structure into a dielectric layer and filling the trench or via with metal. Dielectric layers can comprise dielectric materials such as, for example, low-κ dielectrics, SiO₂, silicon nitride (SiN), silicon carbide (SiC), and/or silicon carbonitride (SiCN). Low-κ dielectric materials include for example, fluorine-doped SiO₂, carbon-doped SiO₂, porous SiO₂, porous carbon-doped SiO₂, combinations for the foregoing, and also these materials with airgaps. Other materials are possible. Dielectric layers that include conducting features can be intermetal dielectric (ILD) features.

Design changes can be implemented on a packaged or unpackaged semiconductor chip using a focused ion beam (FIB) and/or other machining tools to either mill through the silicon substrate down to the transistor layer or to rewire circuit interconnects to implement a logic change on the semiconductor device. Timing changes on a semiconductor device can be achieved by adding capacitance or resistance to a node. Timing can also be shifted by rerouting the signal trace through a buffer or inverter using FIB direct write, machining, and material depositions.

In some devices power and signal input/output (I/O) is delivered through metallization layers on the semiconductor chip surface. Metallization layers typically comprise layers of dielectric and metal traces in the layers of dielectric. Metal traces typically are comprised of copper. In devices where power and signal I/O are delivered on the same side of the chip, optical probing tools can typically be used to view transistors and circuitry through the side of the semiconductor chip that does not power and signal I/O metallization layers (the front side of the semiconductor chip). Techniques including laser-assisted device alteration (LADA), laser voltage probing (LVP), frequency mapping, infrared emission microscopy (IREM) can be used to probe and test circuits from the front side of the semiconductor chip. Typically, the front side of the semiconductor chip is thinned to a thickness of less than 50 nm to facilitate probing. Mechanical probing can be used to probe a target signal after FIB deprocessing of the semiconductor chip. Electron beam (e-beam) probing typically requires exposure of the circuit elements of interest. When a semiconductor chip has metallization layers on the back side and the front side, the front side no longer provides an unobscured view into the semiconductor chip for optical, e-beam, and mechanical probing techniques.

Additional difficulties can arise when semiconductor chips contain transistors that are ribbon field-effect transistors (FETs) and for semiconductor chips having dense transistor placement densities. The ability to access transistors and lower-level metal interconnects is reduced and sometimes impossible using typical sample preparation for probing techniques. Both optical and mechanical probing techniques can have limited signal access and can be impractical for semiconductor devices, such as those containing ribbon FETs and those having dense transistor placement.

A ribbon FET is a type of gate-all-around (GAA) transistor, which can include nanowire FETs and ribbon FETs. Other types of transistors include planar FETs and fin FETs. Field effect transistors typically are metal-oxide-semiconductor field-effect (MOSFET) transistors. A semiconductor device can contain more than one type of transistor.

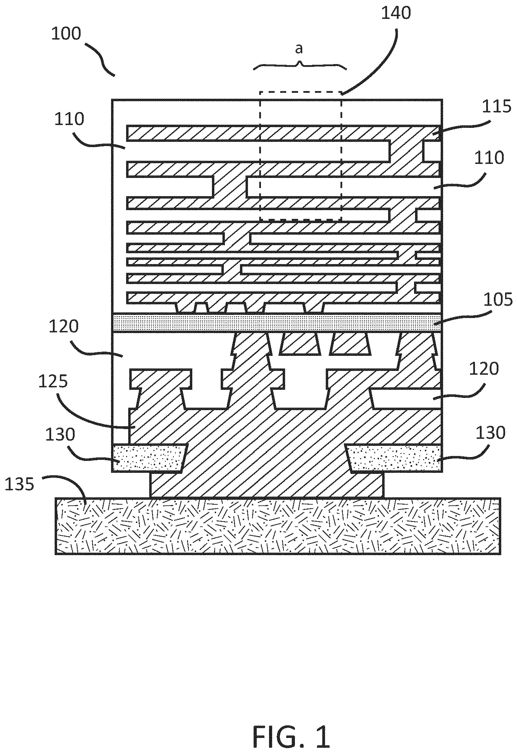

Figure 1 provides a cross-sectional view of an exemplary section of a semiconductor chip 100. The section of a semiconductor chip 100 is selected so that failure analysis and/or fault isolation can be performed. The semiconductor chip can be a standalone (singulated die) device or it can be one of many devices that are housed on a semiconductor wafer. In Figure 1, a section of a semiconductor chip 100 includes a semiconductor device region 105 containing transistors (and other devices, such as for example, capacitors, resistors, diodes, and/or memory cells), a front side metallization region comprising layers of dielectric 110 (individual dielectric layers are not delineated) and metal traces 115. The section of a semiconductor chip 100 also includes a back side metallization region comprising layers of dielectric 120 and metal traces 125. The back side metallization region in this example also has an underfill layer 130 that can be an electrically insulating adhesive or epoxy material that is between the chip and the carrier 135. The dielectric layers 110 and 120 can be ILDs and/or redistribution layers (RDLs). The metal traces 125 can be trenches and vias that have been created in the dielectric regions 110 and 120 that are filled with a metal, such as, for example copper. Other conducting materials are possible. The exemplary section of a semiconductor chip 100 can also optionally include a carrier 135, such as a packaging substrate to which it is electrically coupled. Although the section of an exemplary semiconductor chip 100 is depicted having a front side metallization region and a back side metallization region, it is also possible for an exemplary semiconductor chip 100 to have metallization on one side, for example to have only a front side metallization region. It is sometimes the case that a semiconductor chip has metallization on a first side to provide signal I/O and metallization on a second side that provides power to the semiconductor devices. In other examples, signal I/O and power are provided to the semiconductor chip on one side of the chip.

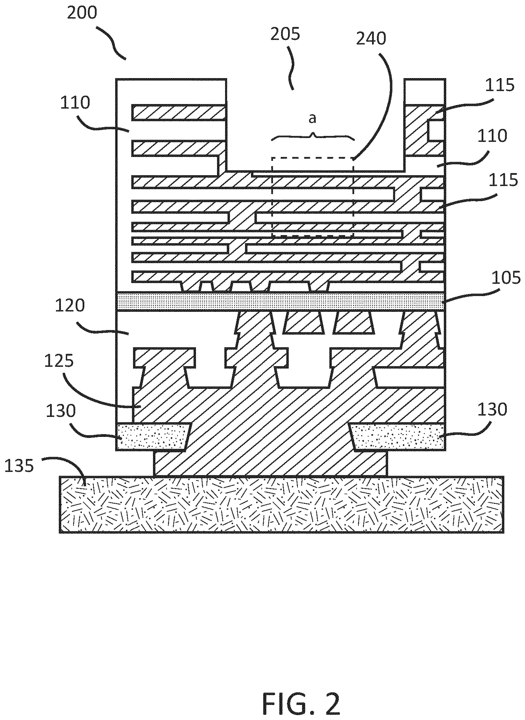

In Figure 2, a cross-sectional view of an exemplary section of an additional semiconductor chip 200 is provided. The section of a semiconductor chip 200 is selected so that failure analysis fault isolation and/or circuit editing can be performed. The semiconductor chip can be a standalone device or it can be one of many that are housed in a semiconductor wafer. In Figure 2, a section of a semiconductor chip 200 includes a semiconductor device region 105 containing transistors and other devices (such as for example, capacitors, resistors, diodes, and/or memory cells), a front side metallization region comprising layers of dielectric 110 (individual layers are not depicted for clarity) and metal traces 115. The section of a semiconductor chip 200 also includes a back side metallization region comprising layers of dielectric 120 and metal traces 125. The back side metallization region in this example also has an underfill layer 130 that can be an electrically insulating adhesive or epoxy material that is between the chip and the carrier 135. The exemplary section of a semiconductor chip 200 also includes a carrier 135, such as a packaging substrate to which it is electrically coupled. Although the section of an exemplary semiconductor chip 200 is depicted having a front side metallization region and a back side metallization region, it is also possible for an exemplary semiconductor chip 100 to have metallization on one side, for example to have only a front side metallization region. Descriptions for Figure 1 are applicable to features of Figure 2 that are numbered similarly. In Figure 2, a section 205 has been delayered to reveal some of the metal traces 115 that are beneath the surface of a semiconductor chip 200 in section 205 (by removing both the dielectric layers 110 and the metal traces 115 in section 205). This delayering process can be performed using, for example, a focused ion beam (FIB) process with a Ne⁺, Ga⁺, Xe⁺, O⁺, Ar", N⁺, or other suitable ion species, in a broad beam ion tool, a reactive ion etcher, or a combination of these tools.

In Figure 1, a region 140 outlined by a dashed line is subjected to a partial etch (or dielectric etch) that removes dielectric 110 but leaves traces 115 in the region 140. In Figure 2, a region 240 outlined by a dashed line is subjected to a dielectric etch that removes dielectric 110 but leaves traces 115 in the region 240. The partial etch that removes dielectric in regions 140 and 240 can be performed using, for example, a focused ion beam (FIB) process with a Ne⁺, Ga⁺, Xe⁺, O⁺, Ar⁺, N⁺, or other suitable ion species. Other techniques for performing a partial etch that removes dielectric, include, for example, gas-assisted etch technologies, including those that employ charged particle beams, neutral particle beams, and proton beams, and inductively coupled plasma reactive ion etching (ICP-RIE). Dielectric beneath the traces 115 can be allowed to remain to provide structural integrity to traces 115 that have been exposed. Metal traces 115 can remain functional after the partial etch process.

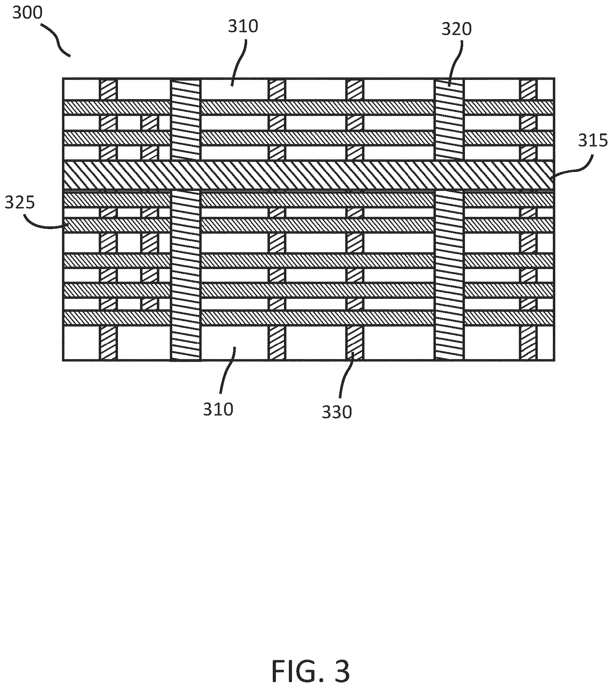

Figure 3 provides a surface view of an exemplary region indicated by "a" in Figures 1 or 2, where a partial etch process removed dielectric from regions 140 or 240, respectively creating a skeleton-like structure of metal traces. In Figure 3, region 300 of an exemplary section "a" of a semiconductor chip 100 or 200, of Figures 1 or 2 respectively, metal traces 315, 320, 325, and 330 are visible as a result of a partial etch process that removed dielectric material. In Figures 1 and 2, not all metal traces are shown, for example, metal traces that are oriented 90 degrees have been omitted. Metal trace 315 can be, for example, a metal level 7 (M7), metal trace 320 can be, for example, a metal level 6 (M6), metal trace 325 can be, for example, a metal level 5 (M5), and metal trace 330 can be, for example, metal level 4 (M4), depending on how many metal levels are present on the side of a semiconductor chip being examined and whether a delayering process is performed and if so how deep a delayering process reaches into the surface of the semiconductor chip. In this example, in which the etch has not penetrated completely to the semiconductor device region 105 containing transistors of Figure 1 or 2, a layer of dielectric 310 is visible through the metal traces 315, 320, 325, and 330. It is also possible that the partial etch could remove dielectric layer to reveal a semiconductor device region 105 (of Figure 1 or 2), so that 310 is a semiconductor region, such as the back side of the semiconductor, that is visible through metal traces 315, 320, 325, and 330. Different depths can be chosen for the partial etch process. In some examples, the partial etch process can expose between 1 and 8 layers of metal traces.

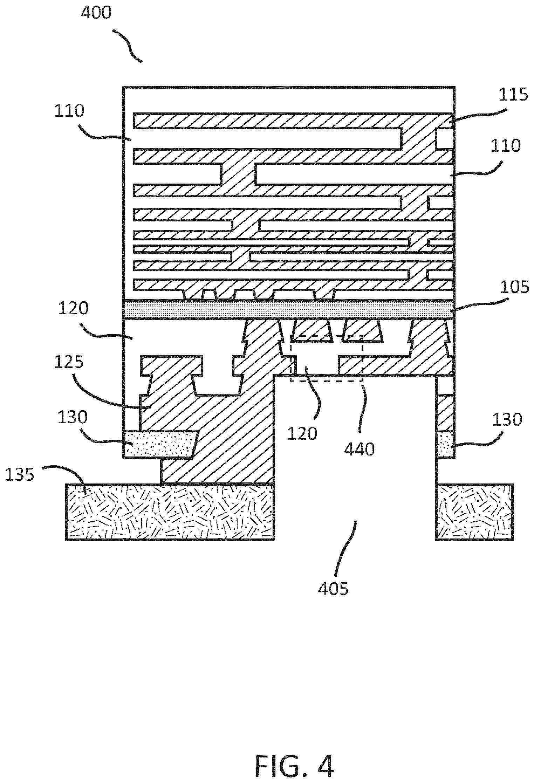

Figure 4 presents an additional exemplary section of a semiconductor chip 400. In Figure 4, a section of a semiconductor chip 400 includes a semiconductor device region 105 containing transistors, a front side metallization region comprising layers of dielectric 110 (individual layers are not depicted for clarity) and metal traces 115. The section of a semiconductor chip 400 also includes a back side metallization region comprising layers of dielectric 120 and metal traces 125. The back side metallization region in this example also has an underfill layer 130 that can be an electrically insulating adhesive or epoxy material that is between the chip and the carrier 135. The carrier 135 can be a packaging substrate to which the semiconductor chip is electrically coupled. Descriptions for features in Figure 1 are applicable to features of Figure 4 that are numbered similarly. In Figure 4, a section 405 has been delayered to reveal metal traces 125 that are beneath the surface of the section of a semiconductor chip 400. A delayering process can be performed using, for example, a focused ion beam (FIB) process with a Ne⁺, Ga⁺, Xe⁺, O⁺, Ar", N⁺, or other suitable ion species, in a broad beam ion tool, a reactive ion etcher, or a combination of these techniques.

In Figure 4, a region 440 outlined by a dashed line is subjected to a partial etch (or dielectric etch) that removes dielectric 120 but leaves traces 125 in the region 440 forming a skeleton-like structure of traces. The skeleton-like structure of traces can be similar to the one of Figure 3. The partial etch that removes dielectric in the region 440 can be performed using, for example, a focused ion beam (FIB) process with a Ne⁺, Ga⁺, Xe⁺, O⁺, Ar⁺, N⁺, or other suitable ion species. Other techniques for performing a partial etch that removes dielectric, include, for example, gas-assisted etch technologies, including those that employ charged particle beams, neutral particle beams, and proton beams, and inductively coupled plasma reactive ion etching (ICP-RIE). Dielectric beneath the traces 115 can be allowed to remain to provide structural integrity to traces 115 that have been exposed. The partial etch can also optionally be performed without first delayering a section of the semiconductor surface (similar to what is shown in Figure 1). The resulting structure is similar to that shown in Figure 3, in that metal traces are now exposed and it is possible to access features beneath the surface of the semiconductor chip on the back side of the semiconductor chip. The number of metal traces exposed and the features that can be accessed depends on the depth of the partial etch. The partial etch can, for example, remove dielectric layers to reveal a semiconductor device region 105, such as the back side of the semiconductor, so that the back side of the semiconductor is visible through metal traces. Different depths can be chosen for the partial etch process.

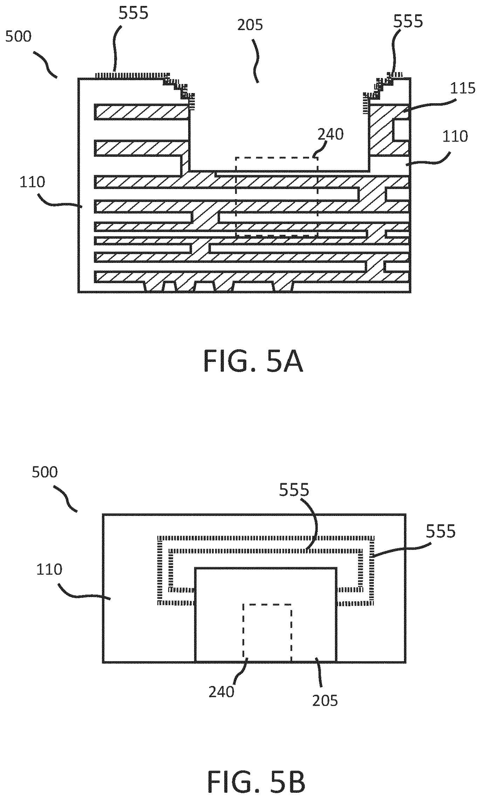

Figure 5A provides an illustration of an exemplary section of a semiconductor chip 500. The section of a semiconductor chip 500 is similar to the front side metallization section of a semiconductor chip 200 shown in Figure 2 and where the feature numbers are the same, the descriptions for the same features with respect to Figures 1 and 2 can be used with respect to Figures 5A and 5B. Similar to Figure 2, a section 205 has been delayered (by removing both the dielectric layers 110 and the metal traces 115 in section 205) to reveal metal traces 115 that are beneath the surface of the section 205. Figure 5A also shows the addition of a conducting trace reconnection 555 that allows current to flow between a missing section of the metal traces 115. Although one conducting trace reconnection 555 is shown, more than one can be used and the conducting trace reconnection 555 can be in one or more different locations. Although the processes of delayering, etch, and conducting trace reconnection are shown with respect to the front side metallization of a semiconductor chip, these process removal and reconnection could also be performed on a back side metallization region of a semiconductor chip. Reconnection of electrical connections for metal traces can be performed, for example, by a FIB conductor deposition process, though wire bonding, or through a combination of FIB conductor deposition and wire bonding. Figure 5B shows a rotated view of the section of the semiconductor chip 500 in which the chip has been rotated 90 degrees and the view is down the z-axis. In Figure 5B, two conducting trace electrical reconnection wires 555 are shown . Other numbers of conducting trace reconnection wires 555 are possible and other placements for the conducting trace reconnection wires 555 are also possible. The conducting trace reconnection process can be a process that restores a previous connection between metal traces or a process that changes signal or power routing by rewiring or otherwise modifying one or more electrical circuit interconnections. Circuits can be edited by reconnecting or modifying interconnects. Circuit edits can be performed to change circuit logic by disconnecting a device input/output and by connecting different logic devices to achieve a desired functional change. For back side metallization, reconnection can also be used to reconnect one or more power rails that were disconnected during a back side delayering process. Metal trace reconnection can also be performed on devices that have not undergone a delayering process to reconnect metal traces that have been exposed through a partial etch process. A trace can be partially exposed and can be disconnected by cutting the interconnect (trace) using a FIB platform. Partially exposed traces can also be connected to another trace through, for example, a FIB conductor deposition process.

The reconnection wire can also be formed, for example, by using an e-beam deposition process such as e-beam physical vapor deposition. A reconnection wire can also be formed by FIB direct write lithography. As an example, the FIB deposition process is FIB induced deposition metal using gas precursors such as, of tungsten hexacarbonyl (W(CO)₆), molybdenum hexacarbonyl (Mo(CO)₈), or dicobalt octacarbonyl (Co₂(CO)₈). Other materials and processes are also possible.

Alternatively traces can be preserved during a delayering process by applying a keep out zone to the delayering area, so that the traces are not disconnected in the keep out zone. The delayering process occurs in areas that are not within the keep out zone. A device that had a keep out zone can also have traces reconnected through a reconnection process, such as, for example, that described with respect to Figures 5A and 5B.

Design changes can be implemented on a semiconductor chip by rewiring circuit interconnects to implement a logic change on the semiconductor device. Timing changes on a semiconductor device can be achieved by adding capacitance or resistance to a node during the reconnection process. Timing can be modified, for example, by adding or removing appropriate logic devices from the circuit through FIB operations. Resistance can be added by cutting a trace and reconnecting it back with a longer FIB deposited conductive wire and controlling the resistance of the conductive wire. Capacitance can be added by FIB deposition of a conductive sheet onto dielectric material in a selected area and connecting the conductive sheet back to a trace for which an additional capacitive load is desired. Timing can also be shifted by rerouting the signal trace through a buffer or inverter during the reconnection process. Device timing alteration can be achieved, for example, by an invasive ion beam that penetrates the surface of the semiconductor device and implants ions in one or more transistor channels. Timing shifts can be created by adding a capacitive load to the device or by routing a device through a highly resistive FIB deposited wire. A FIB can also be used to implant defects into a semiconductor device or alter the resistivity of an existing metal wire.

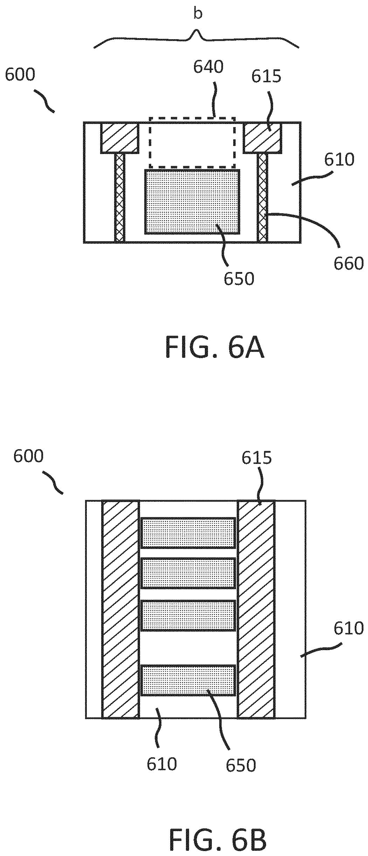

In Figure 6A, a cross-sectional view of a section of a semiconductor chip 600 shows a semiconductor transistor device 650 in a device region 610. The device region 610 can be a dielectric material. The semiconductor transistor device 650 can be, for example, a GAA transistor, such as a ribbon FET or a nanowire FET. Other types of transistors include, for example, planar transistors, dual-gate devices, and fin FETS. Field effect transistors typically are metal-oxide semiconductor field effect (MOSFET) transistors, although other types are possible, such as junction field effect transistors. A FET generally consists of a source region, a drain region, and a gate structure between the source and the drain. The examples described herein are not limited to a particular type of transistor. The semiconductor transistor devices can be on a substrate that optionally has been thinned. The substrate can be, for example, a silicon or silicon-on-insulator substate. Other materials for substrates include, gallium arsenide, germanium, indium antimonide, lead telluride, indium phosphide, indium antimonide, indium gallium arsenide, or gallium antimonide. Other types of substrates are also possible and the examples herein are not limited to a particular type of substrate. In devices having metallization layers on both sides of the substrate, transistors have metal routings on both sides. Additionally, memory arrays can also have metallization layers on both sides of the device array substrate.

As is shown in Figure 6A, a portion of the dielectric layer 610 in dielectric region 640 (outlined by a dashed line) is removed while preserving the power delivery traces 615. Power delivery traces 615 are electrically connected to optional power vias 660 that traverse the device region 610. Power delivery traces 615 can also be BM0, or back metal layer or level 0. BM0 can be part of a back metal power/ground delivery stack which can consist of multiple layers. For example, a stack having layers BM5 (back metal 5) to BM0 is a six layer stack. Back metal routings can also be used for signals that are not power/ground signals, such as, for example, clocks and power-enabling signals. Figure 6B shows a surface-view of the side labeled "b" in Figure 6A of the section of a semiconductor chip 600. A surface of the semiconductor transistor devices 650 is exposed by the dielectric selective removal process in the dielectric region 640 outlined by the dashed line in Figure 6A.

A semiconductor chip can be prepared as shown in Figure 6A, where one layer of metal lines (e.g., BM0), remains, through an ion beam milling process that maintains planarity of the semiconductor chip surface. Copper grain preferential milling artifacts are minimized. For example, using a low ion beam acceleration voltage and low beam current in conjunction with higher chemistry concentration can enhance selective milling of dielectric. This process can enable ILD to recess at a much faster rate than Cu during milling. The layer of metal lines (e.g., BM0) can be functionally preserved while transistor devices are exposed through the recessed dielectric layer. Maintaining planarity of the semiconductor chip surface aids in having a high quality exposed semiconductor transistor device 650 after dielectric in region 640 is removed. The dielectric region 640 can be milled using an ion beam with, for example, a focused ion beam (FIB) process with a Ne⁺, Ga⁺, Xe⁺, O⁺, Ar⁺, N⁺, or other suitable ion species. Other techniques for performing a partial etch that removes dielectric, include, for example, gas-assisted etch technologies, including those that employ charged particle beams, neutral particle beams, and proton beams, and inductively coupled plasma reactive ion etching (ICP-RIE). Ga ion and sputtering Cu implant can be minimized by using beam chemistries that accelerate these materials' removal rate. Cu smearing can be minimized by ion beam rastering along the Cu metallization lines direction The end point of full transistor device reveal can be observed, for example, with FIB images, and with a secondary electron intensity-based graphical endpoint used in conjunction with a visual endpoint. Exposed transistor devices 650 are available for probing with an analysis method (e.g., edit, test, and/or debug) that provides information about the operation of one or more transistors. Exposed transistor devices 650 can be probed, for example, with an e-beam or a laser beam to measure circuit activity via frequency mapping, waveform capture, or logic state imaging. All of these processes may be used but are not limited to determining the boundary of an electrical failure (identifying areas that are working and distinguishing them from those that are not) or measuring a timing error in a repetitive clock or data stream.

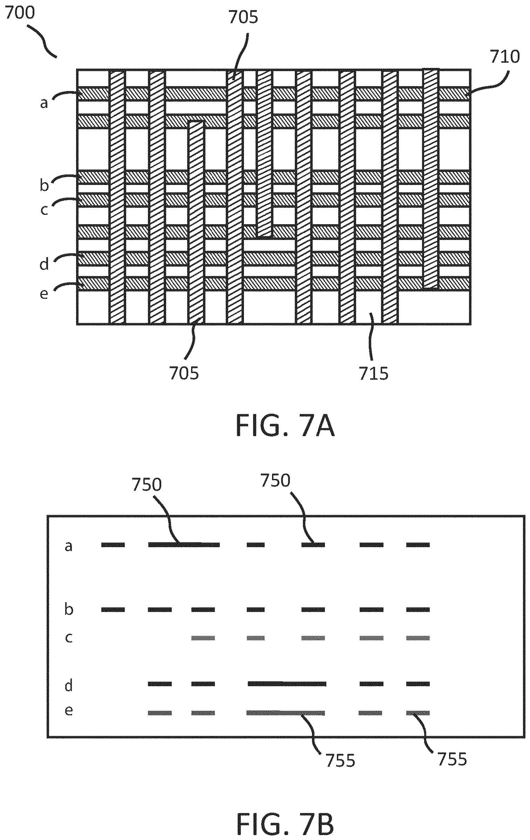

Figures 7A and 7B illustrate exemplary e-beam probing results for metallization layers that have undergone a partial delayering and etch. In Figure 7A, a portion of a semiconductor device 700 that has undergone a partial delayering and etch process, such as, for example, any one of the examples of Figures 1 - 4 and Figures 5A - 5B and their accompanying description herein, is illustrated. The partial etch process on the portion of the semiconductor device 700 removes dielectric while leaving metal traces 705 and 710. Dielectric 715 is beneath metal traces 705 and 710 and can be viewed through the skeleton-like structure formed by metal traces 705 and 710. For simplicity, two layers of metal traces 705 and 710 are shown in this example, but it is possible to have many more, such as for example, as many as 8 - 10 layers exposed for probing. Figure 7B illustrates results from sub-surface e-beam probing of metal lines 710 that are labeled "a," "b," "c," "d," and "e." Phase locked signals 750 and 755 of metal lines 710 that are labeled "a," "b," "c," "d," and "e" obtained from between metal lines 705 are shown. Signals that are in phase 750 with a tester-driven reference signal are illustrated in black ("a," "b," and "d") and out of phase signals 755 are illustrated in grey ("c" and "e"). Overlaying the e-beam probing phase-resolved signal on top of a simultaneously captured scanning electron microscope (SEM) image allows functional circuit traces to be located and distinguished from traces that are not functional.

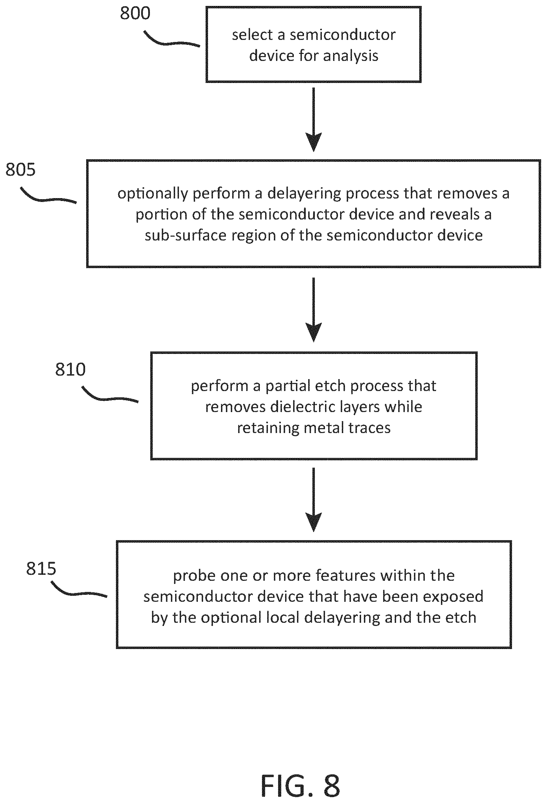

Figure 8 describes a method for performing an analysis on a semiconductor device. The analysis method can be a failure analysis, fault isolation, or other analysis or testing method that explores the operation of the device. Failure analysis methods provide information about the operation of a semiconductor device and can include fault isolation. In the method of Figure 8, a semiconductor chip or device is selected for analysis 800. An optional delayering process is performed on one or more regions of interest of the semiconductor device revealing a sub-surface region of the semiconductor device 805. The optional delayering process can remove metallization layers from the surface of a semiconductor chip. The delayering process can be performed using, for example, a focused ion beam (FIB) process with a Ne⁺, Ga⁺, Xe⁺, O⁺, Ar⁺, N⁺, or other suitable ion species, in a broad beam ion tool, a reactive ion etcher, or a combination of these techniques. Figures 2, 4, and 5 provide examples of devices that have undergone a partial delayering. A partial etch process is performed in one or more regions of interest to remove dielectric from the one or more regions of the semiconductor device 810. The partial etch process can leave metal traces functionally intact, in that they are in a condition that is similar to the condition that they were in before the partial etch process. The exposed metal traces are electrical interconnects that can function in a similar manner to how they functioned before the partial etch process. The partial etch process can leave some dielectric beneath the metal traces. The dielectric beneath the metal traces can provide support. The partial etch process can expose, for example, from 1 to 10 levels of metal traces. The partial etch that removes dielectric in selected regions can be performed using, for example, a focused ion beam (FIB) process with a Ne⁺, Ga⁺, Xe⁺, O⁺, Ar", N⁺, or other suitable ion species. Other techniques for performing a partial etch that removes dielectric, include, for example, gas-assisted etch technologies, including those that employ charged particle beams, neutral particle beams, and proton beams, and inductively coupled plasma reactive ion etching (ICP-RIE). These processes, optional delayering and partial etch can be performed on the back side or the front side or both the back side and the front side of a semiconductor device. Failure analysis can be performed in the areas exposed by the partial etch(es) 815. Failure analysis methods include probing techniques that are, for example optical or mechanical. Probing techniques also include e-beam probing, thermal probing, and mechanical nano-probing. Figures 7A -7B and accompanying descriptions provide exemplary e-beam probing results. Multiple sites on a semiconductor device can be exposed though the processes described herein. Having multiple sites exposed can be useful for investigating a signal as it propagates across a semiconductor device or comparing a signal that is associated with a failing circuit with a duplicate passing region of the semiconductor device. Additionally, the clock skew of a semiconductor device and signal delays across an entire device can be observed to determine the performance of the semiconductor device to obtain its performance to simulation and optimization. Additional device functionality alteration can be achieved by cutting, connecting, and re-routing interconnect layers.

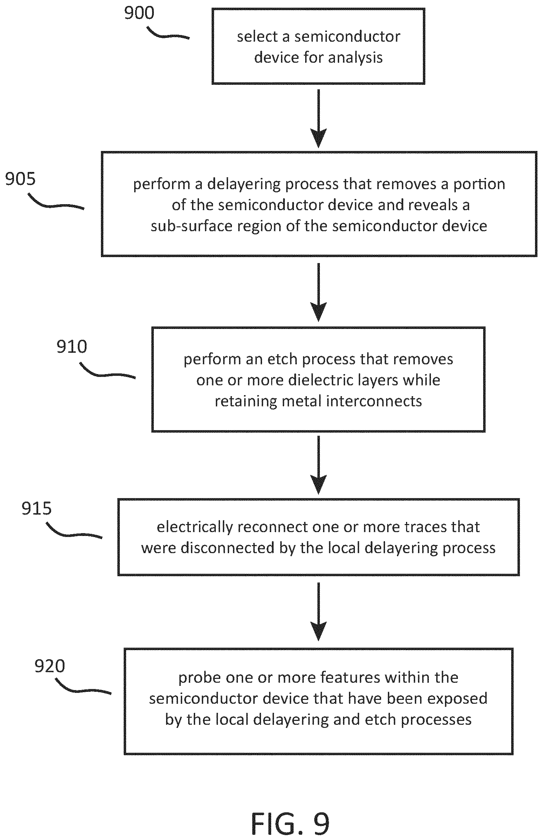

Figure 9 provides a further method for performing failure analysis on a semiconductor device. In the method of Figure 9, a semiconductor chip or device is selected for analysis 900. A delayering process is performed on one or more regions of interest of the semiconductor device revealing a sub-surface region of the semiconductor device 905. The delayering process can remove metallization layers from the surface of a semiconductor chip. The optional delayering process can be performed using, for example, a focused ion beam (FIB) process with a Ne⁺, Ga⁺, Xe⁺, O⁺, Ar⁺, N⁺, or other suitable ion species, in a broad beam ion tool, a reactive ion etcher, or a combination of these techniques. Figures 2 and 5 provide examples of devices that have undergone a partial delayering. A partial etch process is performed in one or more regions of interest to remove dielectric from the one or more regions of the semiconductor device 910. The partial etch process can leave metal traces intact, in that they are in a condition similar to the condition they were in before the partial etch process. The exposed metal traces are electrical interconnects that can function in a similar manner to how they functioned before the partial etch process. The partial etch process can leave some dielectric beneath the metal traces. The dielectric beneath the metal traces can provide support. The partial etch process can expose, for example, from 1 to 10 levels of metal traces. The partial etch that removes dielectric in selected region(s) of interest can be performed using, for example, a focused ion beam (FIB) process with a Ne⁺, Ga⁺, Xe⁺, O⁺, Ar⁺, N⁺, or other suitable ion species. Other techniques for performing a partial etch that removes dielectric, include, for example, gas-assisted etch technologies, including those that employ charged particle beams, neutral particle beams, and proton beams, and inductively coupled plasma reactive ion etching (ICP-RIE). These processes, the delayering and partial etch can be performed on the back side or the front side or both the back side and the front side of a semiconductor device. One or more traces that were severed through the delayering and/or the etch processes are reconnected 915. Additional device functionality and alteration can be achieved by cutting, connecting, and re-routing interconnect layers.

Failure analysis can be performed in the areas exposed by the partial etch(es) 920. Failure analysis methods provide information about the operation of a semiconductor device and can include fault isolation. Failure analysis methods include probing techniques that are, for example optical, mechanical nano-probing, and/or thermal probing. Probing techniques also include e-beam probing. Multiple sites on a semiconductor device can be exposed though the processes described herein. Having multiple sites exposed can be useful for investigating a signal as it propagates across a semiconductor device or comparing a signal that is associated with a failing circuit with a duplicate region of the semiconductor device that is not failing. Additionally, the clock skew of a semiconductor device and signal delays across an entire device can be observed to determine the performance of the semiconductor device to obtain its performance to simulation and optimization. Metal trace reconnection 915 can also be performed on devices that have not undergone a delayering process to reconnect metal traces that have been exposed through a partial etch process. Metal trace reconnections are shown for semiconductor devices, for example, in Figures 5A - 5B and elaborated in the accompanying description herein. Other designs are also possible.

Semiconductor devices processed according to descriptions herein can be kept in controlled environments to minimize contamination, oxidation, and/or corrosion. A controlled environment can be one with a vacuum or an inert gas that does not contain, for example, corrosive species, such as, oxygen, water, or particulate matter. The controlled environment extends the life of the etched or otherwise exposed or prepared semiconductor device for testing and analysis.

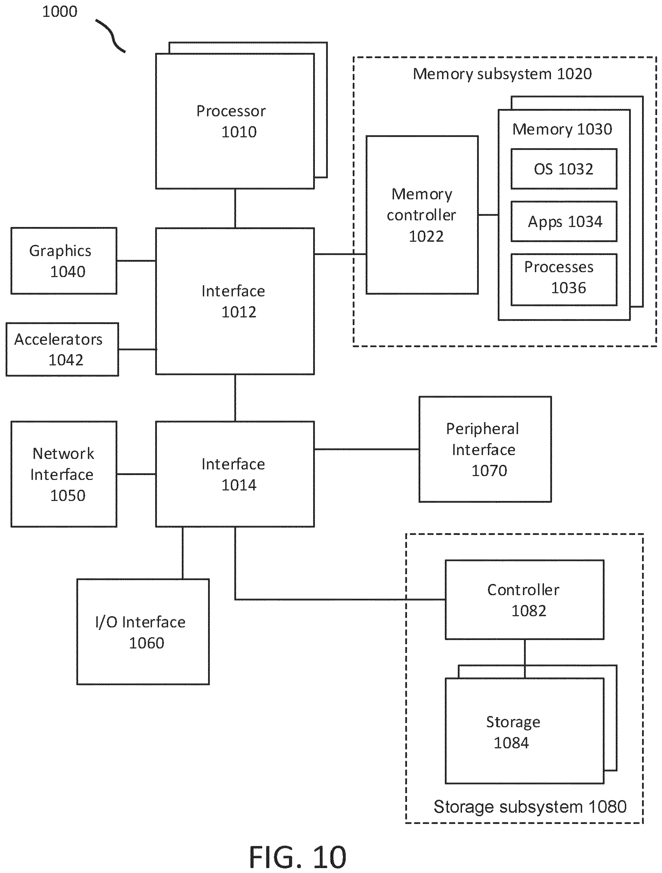

Figure 10 depicts an example computing system which can be used in conjunction with one or more delayering, partial etch, and metallization processes and/or analysis processes described herein. The computing system can be a system used for running equipment and/or instruments in a semiconductor fabrication plant, including instruments for testing and analysis. For example, instructions for operating semiconductor equipment, or for performing one or more aspects of the process described herein can be stored and/or run on the computing system. Interfaces can be provided user input and sample analysis. The computing system employed can include more, different, or fewer features than the one described with respect to Figure 10.

Computing system 1000 includes processor 1010, which provides processing, operation management, and execution of instructions for system 1000. Processor 1010 can include any type of microprocessor, CPU (central processing unit), GPU (graphics processing unit), processing core, or other processing hardware to provide processing for system 1000, or a combination of processors or processing cores. Processor 1010 controls the overall operation of system 1000, and can be or include, one or more programmable general-purpose or special-purpose microprocessors, DSPs, programmable controllers, ASICs, programmable logic devices (PLDs), or the like, or a combination of such devices.

In one example, system 1000 includes interface 1012 coupled to processor 1010, which can represent a higher speed interface or a high throughput interface for system components needing higher bandwidth connections, such as memory subsystem 1020 or graphics interface components 1040, and/or accelerators 1042. Interface 1012 represents an interface circuit, which can be a standalone component or integrated onto a processor die. Where present, graphics interface 1040 interfaces to graphics components for providing a visual display to a user of system 1000. In one example, the display can include a touchscreen display.

Accelerators 1042 can be a fixed function or programmable offload engine that can be accessed or used by a processor 1010. For example, an accelerator among accelerators 1042 can provide data compression (DC) capability, cryptography services such as public key encryption (PKE), cipher, hash/authentication capabilities, decryption, or other capabilities or services. In some cases, accelerators 1042 can be integrated into a CPU socket (e.g., a connector to a motherboard (or circuit board, printed circuit board, mainboard, system board, or logic board) that includes a CPU and provides an electrical interface with the CPU). For example, accelerators 1042 can include a single or multi-core processor, graphics processing unit, logical execution unit single or multi-level cache, functional units usable to independently execute programs or threads, application specific integrated circuits (ASICs), neural network processors (NNPs), programmable control logic, and programmable processing elements such as field programmable gate arrays (FPGAs) or programmable logic devices (PLDs). Accelerators 1042 can provide multiple neural networks, CPUs, processor cores, general purpose graphics processing units, or graphics processing units can be made available for use by artificial intelligence (Al) or machine learning (ML) models.

Memory subsystem 1020 represents the main memory of system 1000 and provides storage for code to be executed by processor 1010, or data values to be used in executing a routine. Memory subsystem 1020 can include one or more memory devices 1030 such as read-only memory (ROM), flash memory, one or more varieties of random access memory (RAM) such as static RAM (SRAM), dynamic RAM (DRAM), synchronous DRAM (SDRAM) and/or or other memory devices, or a combination of such devices. Memory 1030 stores and hosts, among other things, operating system (OS) 1032 that provides a software platform for execution of instructions in system 1000, and stores and hosts applications 1034 and processes 1036. In one example, memory subsystem 1020 includes memory controller 1022, which is a memory controller to generate and issue commands to memory 1030. The memory controller 1022 could be a physical part of processor 1010 or a physical part of interface 1012. For example, memory controller 1022 can be an integrated memory controller, integrated onto a circuit within processor 1010.

System 1000 can also optionally include one or more buses or bus systems between devices, such memory buses, graphics buses, and/or interface buses. Buses or other signal lines can communicatively or electrically couple components together, or both communicatively and electrically couple the components. Buses can include physical communication lines, point-to-point connections, bridges, adapters, controllers, or other circuitry or a combination. Buses can include, for example, one or more of a system bus, a peripheral component interface (PCI) or PCI express (PCIe) bus, a Hyper Transport or industry standard architecture (ISA) bus, a small computer system interface (SCSI) bus, a universal serial bus (USB), or a Firewire bus.

In one example, system 1000 includes interface 1014, which can be coupled to interface 1012. In one example, interface 1014 represents an interface circuit, which can include standalone components and integrated circuitry. In one example, user interface components or peripheral components, or both, couple to interface 1014. Network interface 1050 provides system 1000 the ability to communicate with remote devices (e.g., servers or other computing devices) over one or more networks. Network interface 1050 can include an Ethernet adapter, wireless interconnection components, cellular network interconnection components, USB, or other wired or wireless standards-based or proprietary interfaces. Network interface 1050 can transmit data to a device that is in the same data center or rack or a remote device, which can include sending data stored in memory.

Some examples of network interface 1050 are part of an infrastructure processing unit (IPU) or data processing unit (DPU), or used by an IPU or DPU. An xPU can refer at least to an IPU, DPU, GPU, GPGPU (general purpose computing on graphics processing units), or other processing units (e.g., accelerator devices). An IPU or DPU can include a network interface with one or more programmable pipelines or fixed function processors to perform offload of operations that could have been performed by a CPU. The IPU or DPU can include one or more memory devices.

In one example, system 1000 includes one or more input/output (I/O) interface(s) 1060. I/O interface 1060 can include one or more interface components through which a user interacts with system 1000 (e.g., audio, alphanumeric, tactile/touch, or other interfacing). Peripheral interface 1070 can include additional types of hardware interfaces, such as, for example, interfaces to semiconductor fabrication equipment and/or electrostatic charge management devices.

In one example, system 1000 includes storage subsystem 1080. Storage subsystem 1080 includes storage device(s) 1084, which can be or include any conventional medium for storing data in a nonvolatile manner, such as one or more magnetic, solid state, and/or optical based disks. Storage 1084 can be generically considered to be a "memory," although memory 1030 is typically the executing or operating memory to provide instructions to processor 1010. Whereas storage 1084 is nonvolatile, memory 1030 can include volatile memory (e.g., the value or state of the data is indeterminate if power is interrupted to system 1000). In one example, storage subsystem 1080 includes controller 1082 to interface with storage 1084. In one example controller 1082 is a physical part of interface 1012 or processor 1010 or can include circuits or logic in both processor 1010 and interface 1014.

A power source (not depicted) provides power to the components of system 1000. More specifically, power source typically interfaces to one or multiple power supplies in system 1000 to provide power to the components of system 1000.

Besides what is described herein, various modifications can be made to what is disclosed and implementations of the invention without departing from their scope. Therefore, the illustrations and examples herein should be construed in an illustrative, and not a restrictive sense. The scope of the invention should be measured by reference to the claims that follow.
The following section of the description relates to further examples. The numbered paragraphs in this section are not claims. The claims are set forth below in the later section headed "claims".
1. A semiconductor device comprising:
   a semiconductor device region comprising transistors;
   a first metallization region on a first surface of the semiconductor device region; and
   a second metallization region on a second surface of the semiconductor device region wherein the second metallization region comprises metal traces in levels, wherein the metal traces are in layers of dielectric, wherein a first selected region of the second metallization region is without dielectric, and wherein metal traces in the first selected region of the second metallization region are exposed.
2. The semiconductor device of clause 1 wherein metal traces in the first selected region of the second metallization region are electrical interconnects.
3. The semiconductor device of clause 1 wherein dielectric is beneath metal traces in the first selected region of the second metallization region.
4. The semiconductor device of clause 1 wherein metal traces in from one to eight levels of metal traces are exposed in the first selected region of the second metallization region.
5. The semiconductor device of clause 1 wherein a second selected region of the second metallization region is delayered and wherein a metal trace in the second selected region is electrically reconnected.
6. The semiconductor device of clause 1 wherein the first metallization region is capable of delivering power to the semiconductor device region.
7. A semiconductor device comprising:
   a semiconductor device region comprising at least one transistor wherein the at least one transistor has a surface and the surface is exposed; and
   a region of metal traces comprising one level of metal traces, wherein the metal traces are on a first surface of the semiconductor device region, and wherein the metal traces of the one level of metal traces are exposed.
8. The semiconductor device of clause 7 wherein the at least one transistor is a gate-all-around transistor.
9. The semiconductor device of clause 7 wherein the at least one transistor is a ribbon field effect transistor.
10. The semiconductor device of clause 7 wherein the semiconductor device region also comprises conducting vias and the metal traces are electrically connected to the conducting vias.
11. The semiconductor device of clause 7 wherein the semiconductor device has a backside metallization region and a front side metallization region.
12. A method for analyzing a semiconductor device comprising:
   selecting a region of a semiconductor device for analysis wherein the region comprises a plurality of layers of dielectric material and the plurality of layers of dielectric material comprise metal traces;
   performing a partial etch process in the region of the semiconductor device, wherein the partial etch process removes dielectric material from the region but allows metal traces to remain and wherein the partial etch process exposes metal traces that are sub-surface metal traces of the semiconductor device; and
   probing the region of the semiconductor device with an analysis method that provides information about operation of the semiconductor device.
13. The method of clause 12 wherein the semiconductor device has a back side metallization region and a front side metallization region.
14. The method of clause 12 wherein the semiconductor device has a back side and a front side metallization region and the region of the semiconductor device is in the front side metallization region.
15. The method of clause 12 wherein the partial etch process is performed using a focused ion beam.
16. The method of clause 12 wherein the partial etch process exposes metal traces that are in at least three different layers of the plurality of layers of dielectric material.
17. The method of clause 12 also including performing a delayering process in the region of the semiconductor device wherein the delayering process removes at least one layer of the plurality of layers of dielectric material and removes metal traces in the at least one layer of the plurality of layers of dielectric material.
18. The method of clause 17 wherein the delayering process is performed using a focused ion beam.
19. The method of clause 17 also including electrically reconnecting one or more traces that were disconnected by the delayering process.
20. The method of clause 12 wherein the partial etch process is performed using a focused ion beam with a Ne⁺, Ga⁺, Xe⁺, O⁺, Ar", or N⁺ ion source.

## Claims

1. A semiconductor device comprising:
a semiconductor device region comprising transistors;
a first metallization region on a first surface of the semiconductor device region; and
a second metallization region on a second surface of the semiconductor device region
wherein the second metallization region comprises metal traces in levels, wherein the metal traces are in layers of dielectric, wherein a first selected region of the second metallization region is without dielectric, and wherein metal traces in the first selected region of the second metallization region are exposed.

2. The semiconductor device of claim 1 wherein metal traces in the first selected region of the second metallization region are electrical interconnects.

3. The semiconductor device of claim 1 wherein dielectric is beneath metal traces in the first selected region of the second metallization region.

4. The semiconductor device of claim 1 wherein metal traces in from one to eight levels of metal traces are exposed in the first selected region of the second metallization region.

5. The semiconductor device of claim 1 wherein a second selected region of the second metallization region is delayered and wherein a metal trace in the second selected region is electrically reconnected.

6. The semiconductor device of claim 1 wherein the first metallization region is capable of delivering power to the semiconductor device region.

7. A method for analyzing a semiconductor device comprising:
selecting a region of a semiconductor device for analysis wherein the region comprises a plurality of layers of dielectric material and the plurality of layers of dielectric material comprise metal traces;
performing a partial etch process in the region of the semiconductor device, wherein the partial etch process removes dielectric material from the region but allows metal traces to remain and wherein the partial etch process exposes metal traces that are sub-surface metal traces of the semiconductor device; and
probing the region of the semiconductor device with an analysis method that provides information about operation of the semiconductor device.

8. The method of claim 12 wherein the semiconductor device has a back side and a front side metallization region and the region of the semiconductor device is in the front side metallization region.

9. The method of claim 12 wherein the partial etch process exposes metal traces that are in at least three different layers of the plurality of layers of dielectric material.

10. The method of claim 12 also including performing a delayering process in the region of the semiconductor device wherein the delayering process removes at least one layer of the plurality of layers of dielectric material and removes metal traces in the at least one layer of the plurality of layers of dielectric material.

11. The method of claim 17 also including electrically reconnecting one or more traces that were disconnected by the delayering process.

12. The method of claim 12 wherein the partial etch process is performed using a focused ion beam with a Ne⁺, Ga⁺, Xe⁺, O⁺, Ar", or N⁺ ion source.

13. A computer-readable medium on which instructions are stored in a non-transitory form, that when executed by a computer, cause a system to perform the method of:
selecting a region of a semiconductor device for analysis wherein the region of the semiconductor device has a surface and wherein the region comprises one or more sub-surface transistors;
removing metallization layers from the region of the of the semiconductor device wherein at least one metallization layer remains;
planarizing the surface of the region of the semiconductor device;
performing a partial etch process on the region of the semiconductor device, wherein the partial etch process removes dielectric material from the region but allows metal traces to remain; and
probing the region of the semiconductor device with an analysis method that provides information about operation of one or more sub-surface transistors.

14. The computer-readable medium of claim 24 wherein performing the partial etch process includes using a focused ion beam with a with a Ne⁺, Ga⁺, Xe⁺, O⁺, Ar⁺, or N⁺ ion source.

15. The computer-readable medium of claim 24 wherein planarizing the surface of the region is performed by a focused ion beam.
